(19) Europäisches Patentamt
European Patent Office
Office européen des brevets

(11) **EP 3 579 416 A1**

(12) **EUROPEAN PATENT APPLICATION**

(43) Date of publication:
**11.12.2019 Bulletin 2019/50**

(51) Int Cl.:
*H03K 23/64* (2006.01)    *H03K 23/66* (2006.01)

(21) Application number: **19176607.0**

(22) Date of filing: **24.05.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.06.2018 US 201816003337**

(71) Applicant: **NXP B.V.**
**5656 AG Eindhoven (NL)**

(72) Inventors:
• **OSORIO TAMAYO, Juan Felipe**
**5656 AG Eindhoven (NL)**

• **VELANDIA TORRES, Javier Mauricio**
**5656 AG Eindhoven (NL)**
• **SARIC, Tarik**
**5656 AG Eindhoven (NL)**
• **APOSTOLIDOU, Melina**
**5656 AG Eindhoven (NL)**

(74) Representative: **Hardingham, Christopher Mark**
**NXP Semiconductors**
**Intellectual Property Group**
**Abbey House**
**25 Clarendon Road**
**Redhill, Surrey RH1 1QZ (GB)**

(54) **FREQUENCY DIVISION CIRCUITRY AND METHODS**

(57)    Aspects of the disclosure are directed to multi-module frequency division. As may be implemented in accordance with one or more embodiments herein, an apparatus (100) includes latching circuitry (110) having three or fewer vertically-stacked transistors between power rails (fig. 2b), which operate to provide output signals (Fo1) from input signals (Fin), the output signals having a frequency that is a divided representation (1/3 or 1/2) of the frequency of the input signals. A pulse widening circuit (120, fig. 3: 300) modifies the output signals (Fo1) by widening a pulse thereof, providing a modified output signal (Fo1*). A further latching circuit (112, 114 116) may be utilized to perform a further frequency division of the modified output signal (Fo1*). The respective latching circuitry (112, 114, 116) can be used to selectively provide frequency-divided output signals (Fo2, Fon-1, Fon) from input signals at respective divided frequencies (1/3, 1/2).

FIG. 1A

**Description**

Aspects of various embodiments are directed to one or more methods and/or apparatuses for providing frequency division. Such approaches may be implemented for low-power frequency division that also achieves high frequencies.

A variety of circuit applications utilize frequency dividing circuits, for a multitude of disparate purposes. Generally, a frequency dividing circuit provides an output signal that is a representation of a received input signal, having a frequency thereof divided. Such circuits can be used in analog and digital applications, such as for general communication circuitry, mobile telephones, automotive applications, and radio frequency (RF) transmission.

One type of frequency divider circuit includes multi-module frequency dividers, which may be used in integrated circuits as, for example, subcomponents of a phase-locked loop (PLL) or to generate internal clocks from a high reference frequency.

While frequency dividers are very useful, they have had certain limitations. For instance, some frequency dividers require an amount of power that is undesirably high. This limitation is particularly burdensome for mobile electronic devices and other battery-powered devices. While power savings can be achieved, the resulting signal processing may be subject to inaccuracies, and such power savings may not be achievable with high frequency signals.

These and other matters have presented challenges to efficiencies and operation of frequency dividers and, in general, frequency division approaches, for a variety of applications.

SUMMARY

Various example embodiments are directed to issues such as those addressed above and/or others which may become apparent from the following disclosure concerning frequency division. Such embodiments may facilitate frequency division that consumes relatively low power while providing high frequency signals.

In accordance with a more specific embodiment, a multi-module frequency divider circuit includes first and second latching circuits, and a pulse widening circuit. The first latching circuit has N vertically-stacked transistors between power rails, where N is less than or equal to three, and is configured and arranged to provide an output signal. The second latching circuit has an input circuit configured and arranged to latch an input signal derived from the output signal of the first latching circuit. The pulse widening circuit is configured to modify a signal derived from the output signal from the first latching circuit to cause the second latching circuit to effect a latching operation as part of a multi-module frequency division operation involving both the first and second latching circuits.

In a more specific example embodiment, a method and/or apparatus involves a latching circuit having N vertically-stacked transistors between power rails, where N is less than or equal to three, and a pulse widening circuit. The latching circuit is configured and arranged to receive an input signal having a frequency, select one of at least two integers for frequency division based upon a control signal, and divide the frequency of the input signal by the selected one of the at least two integers to provide an output signal as a frequency-divided representation of the input signal. The pulse widening circuit is configured to modify the output signal by widening a pulse of the output signal. In some embodiments, at least one additional latching circuit is configured and arranged to receive the output signal from the first latching circuit, and to divide the frequency of the output signal to provide a further output signal having a frequency that is a divided representation of the frequency of the output signal from the first latching circuit.

Another embodiment is directed to a method for multi-module frequency division, as follows. An output signal is provided from an input signal using a first latching circuit having N vertically-stacked transistors between power rails, where N is less than or equal to three. A signal derived from the output signal from the first latching circuit is modified with a pulse widening circuit, therein providing a modified output signal. The modified output signal is latched in a second latching circuit having an input circuit that is configured to receive the modified output signal from the pulse widening circuit, as part of a multi-module frequency division operation involving both the first and second latching circuits.

The above discussion/summary is not intended to describe each embodiment or every implementation of the present disclosure. The figures and detailed description that follow also exemplify various embodiments.

BRIEF DESCRIPTION OF FIGURES

Various example embodiments may be more completely understood in consideration of the following detailed description in connection with the accompanying drawings, in which:

FIG. 1A shows a frequency divider apparatus, in accordance with the present disclosure;
FIG. 1B shows a frequency divider cell as may be implemented with Figure 1A, in accordance with the present disclosure;
FIG. 2A illustrates a frequency divider circuit, in accordance with the present disclosure;

FIG. 2B shows a latching circuit, which may be implemented in connection with FIG. 2A, in accordance with the present disclosure;

FIG. 2C shows a latching circuit, which may be implemented in connection with FIG. 2A, in accordance with the present disclosure;

FIG. 3 shows a pulse-widening circuit, as may be implemented in accordance with one or more aspects of the disclosure; and

FIG. 4 shows plots of an input signal, output signal and pulse-widened output signal, as may be implemented in accordance with one or more aspects of the disclosure.

While various embodiments discussed herein are amenable to modifications and alternative forms, aspects thereof have been shown by way of example in the drawings and will be described in detail. It should be understood, however, that the intention is not to limit the disclosure to the particular embodiments described. On the contrary, the intention is to cover all modifications, equivalents, and alternatives falling within the scope of the disclosure including aspects defined in the claims. In addition, the term "example" as used throughout this application is only by way of illustration, and not limitation.

DETAILED DESCRIPTION

Aspects of the present disclosure are believed to be applicable to a variety of different types of apparatuses, systems and methods involving frequency division. In certain implementations, aspects of the present disclosure have been shown to be beneficial when used in the context of dividing the frequency of incoming signals with selective implementation for selecting a factor by which the frequency of the incoming signals are divided. In some embodiments, respective latching circuits are implemented with a pulse-widening circuit that widens the pulse of a frequency-divided output of one of the latching circuits, and provides the widened frequency-divided output to the other one of the latching circuits as an input. The pulse widening is carried out to provide a pulse width that is sufficient to ensure that the other one of the latching circuits can indeed latch the widened frequency-divided output. In connection with this approach, it has been recognized/discovered that latching circuitry with a relatively low (*e.g.,* three or less) number of transistors can be utilized to provide a high frequency output signal using relatively low power, while ensuring that the high frequency output signal has a pulse with that allows it to be reliably latched. The second one of the latching circuits may further divide the frequency of the widened frequency-divided output. While not necessarily so limited, various aspects may be appreciated through the following discussion of non-limiting examples which use exemplary contexts.

In certain embodiments, a type of D-latch and a multi-modules frequency divider operates at high frequency and low power. The circuits operate with current technologies at frequencies only a fraction lower than a current mode logic (CML) divider or a class AB divider, and consume significantly lower power. Such embodiments are suited to advanced CMOS technologies with low supply voltages.

Various circuits as disclosed herein can be used in a phase locked loop (PLL), such as those involving high-frequency/low-power operation (*e.g.,* frequencies as high as around 13GHz in CMOS 45nm with power consumptions lower than 5mA). Such approaches may be utilized with a chirp generator for radar systems, UWB range measuring circuits, wireless transceivers, and cellular transceivers. Operation frequencies of 12GHz are possible in a 45nm CMOS technology and can be scaled with technology.

Accordingly, in the following description various specific details are set forth to describe specific examples presented herein. It should be apparent to one skilled in the art, however, that one or more other examples and/or variations of these examples may be practiced without all the specific details given below. In other instances, well known features have not been described in detail so as not to obscure the description of the examples herein. For ease of illustration, the same reference numerals may be used in different diagrams to refer to the same elements or additional instances of the same element. Also, although aspects and features may in some cases be described in individual figures, it will be appreciated that features from one figure or embodiment can be combined with features of another figure or embodiment even though the combination is not explicitly shown or explicitly described as a combination.

In accordance with one or more embodiments, a multi-module frequency divider circuit includes first and second latching circuits, and a pulse widening circuit. The first latching circuit has three or fewer vertically-stacked transistors between power rails. The second latching circuit is configured to latch an input signal derived from an output signal of the first latching circuit that is modified by the pulse widening circuit. For instance, in accordance with the above-noted recognition/discovery, the pulse widening circuit may modify the output signal from the first latching circuit to facilitate a latching operation in the second latching circuit. These approaches may be carried out as part of a multi-module frequency division operation involving both the first and second latching circuits.

In some embodiments, a feedback circuit provides a feedback signal from the second latching circuit to the first latching circuit. The first latching circuit is responsive to the feedback circuit by dividing by a first integer in the presence of the feedback signal, and by dividing by a second integer in the absence of the feedback signal.

The first latching circuit may be implemented in a variety of manners. For instance, the first latching circuit may include multiple latches, each having no more than three vertically-stacked transistors. Such a circuit may be part of a frequency divider circuit having a plurality of latches including the first latching circuit. In some embodiments, the first latching circuit includes a latch cell having a clocked input port, a signal input port, and a signal output port that provides, in response to a signal at the clocked input port, a latched output signal corresponding to a signal at the signal input port. The first latching circuit may include, for one or more embodiments, a plurality of latch cells (two or more of which being modified with an AND gate) having a clocked input port, a signal input port, and a signal output port that provides, in response to a signal at the clocked input port, a latched output signal corresponding to a signal at the signal input port. In some embodiments, the first latching circuit operates to divide the frequency of an incoming signal by one of two or more different integers that are selected based on an input select signal provided to the first latching circuit.

In a particular embodiment, the first latching circuit includes an input latch circuit, an output latch circuit, and a feedback loop. The output latch circuit has an input port connected to receive an output of the input latch circuit. The feedback loop includes a first feedback latch circuit connected to receive an output of the output latch circuit, and a second feedback latch circuit having an input port connected to receive an output of the first feedback latch circuit. The second feedback latch circuit has an output connected to an input of the input latch circuit. In some implementations, the input latch circuit, output latch circuit, first feedback latch circuit and second feedback latch circuit include D-latches. The input latch circuit, first feedback latch circuit and second feedback latch circuit each further have an AND gate connected to a D-input port of their D-latch.

The first and second latching circuits may, for example, be implemented as frequency divider circuits, each being configured to divide the frequency of a signal input thereto by an integer. In some implementations, the respective latching circuits divide the frequency of the signal input to the first latching circuit by a plurality of different values, based on respective combinations of input select signals provided to each latching circuit. The resulting frequency divided signal is provided at an output of the second latching circuit.

The pulse widening circuit can be implemented in a variety of manners. In some embodiments, the pulse widening circuit is configured to modify the signal derived from the output signal from the first latching circuit by stretching or delaying the signal. In particular embodiments, the pulse widening circuit operates with the first latching circuit to modify the signal derived from the output signal of the first latching by widening a pulse of the output signal of the first latching circuit and therein facilitating the second latching circuit's ability to detect the widened pulse.

Various embodiments are directed to methods for multi-module frequency division, which may for example use apparatuses as characterized herein. An output signal is provided from an input signal using a first latching circuit having three or fewer vertically-stacked transistors between power rails. The first latching circuit may, for example, be implemented with multiple latches, each having no more than three vertically-stacked transistors. A signal derived from the output signal from the first latching circuit is modified with a pulse widening circuit to provide a modified output signal having a widened pulse. Consistent with the above-noted discovery/recognition, widening the pulse in this regard can facilitate the ability of the signal to be subsequently latched (*e.g.,* by widening to a width that is sufficiently wide to facilitate subsequent latching of the modified output signal). Accordingly, the modified output signal is latched in a second latching circuit, as part of a multi-module frequency division operation involving both the first and second latching circuits. In certain embodiments, the frequency of the input signal is divided by one of two or more different integers, based on an input select signal.

In some embodiments, the output signal is provided from the first input signal using the first latching circuit to divide the frequency of the input signal to provide the output signal as a frequency-divided representation of the input signal. The frequency of the modified output signal is then divided by the second latching circuit to provide a further output signal as a frequency-divided representation of the modified output signal.

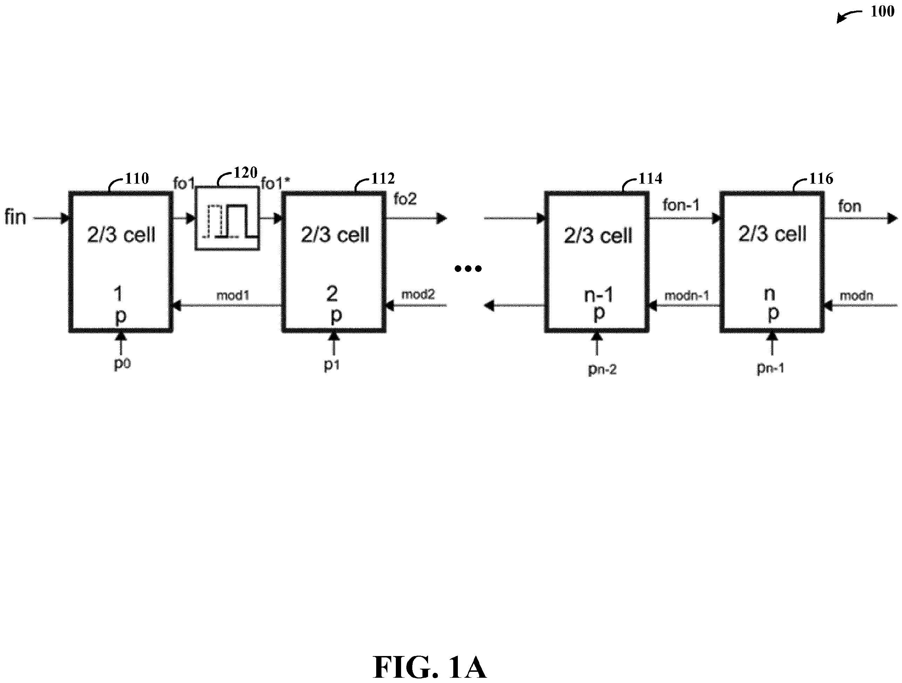

Turning now to the Figures, Figure 1A shows a frequency divider apparatus 100, in accordance with the present disclosure. The apparatus 100 includes latching circuitry 110, 112, 114 and 116, and a pulse widening circuity 120 that widens pulses in an output signal fo1 from latching circuitry 110, and provides output signal fo1* as a pulse-widened version thereof as the input to latching circuitry 112. Consistent with the above recognition/discovery, widening the pulses allows the latching circuitry 112 to properly latch signal fo1* while also facilitating the use of relatively low power at the latching circuitry 110.

In some implementations, the latching circuitry in apparatus 100 is programed by bits po, p1 ... pn-2 and pn-1. The mod signals are "propagated" from the lower frequency cells, toward the higher frequency cells one time. The equation of the period at the output of the last cell compared with the period of the input signal may be implemented as follows:

$$T_{out} = \left(2^n + 2^{n-1}p_{n-1} + 2^{n-2}p_{n-2} + \ldots + 2p_1 + p_0\right)T_{in}$$

One or more of latching circuits 112, 114 and 116 may, for example, utilize circuit componentry based on that disclosed in B. Razavi, RF Microelectronics (2Nd Edition) (Prentice Hall Communications Engineering and Emerging Technologies Series), 2nd ed. Upper Saddle River, NJ, USA: Prentice Hall Press, 2011, which is fully incorporated herein by reference.

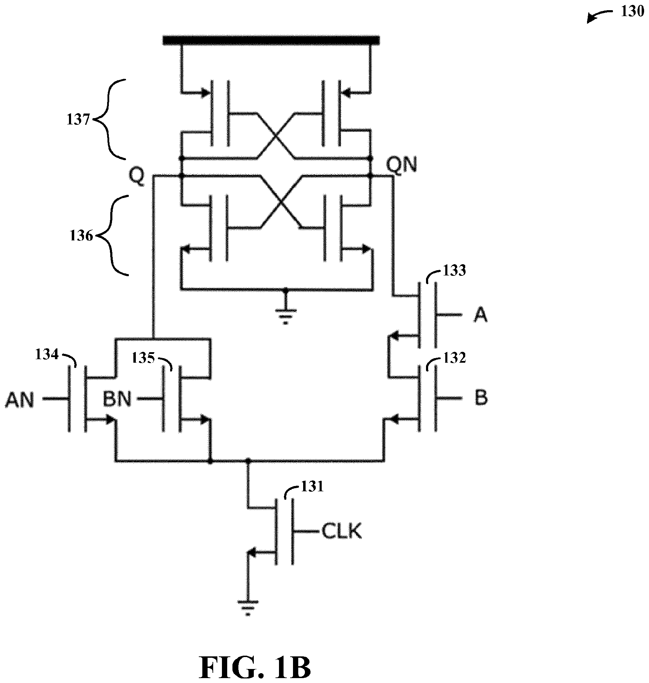

Figure 1B shows a frequency divider cell 130 as may be implemented with Figure 1A, in accordance with the present disclosure. For instance, cell 130 may be implemented with one or more of latching circuits 112, 114 and 116, with latching circuit 110 being implemented at a higher frequency. The cell 130 includes a transistor 131 that is coupled to a clocking input for operating the cell, a set of transistors 132 and 133 in series, a set of transistors 134 and 135 in parallel, and latching circuits 136 and 137.

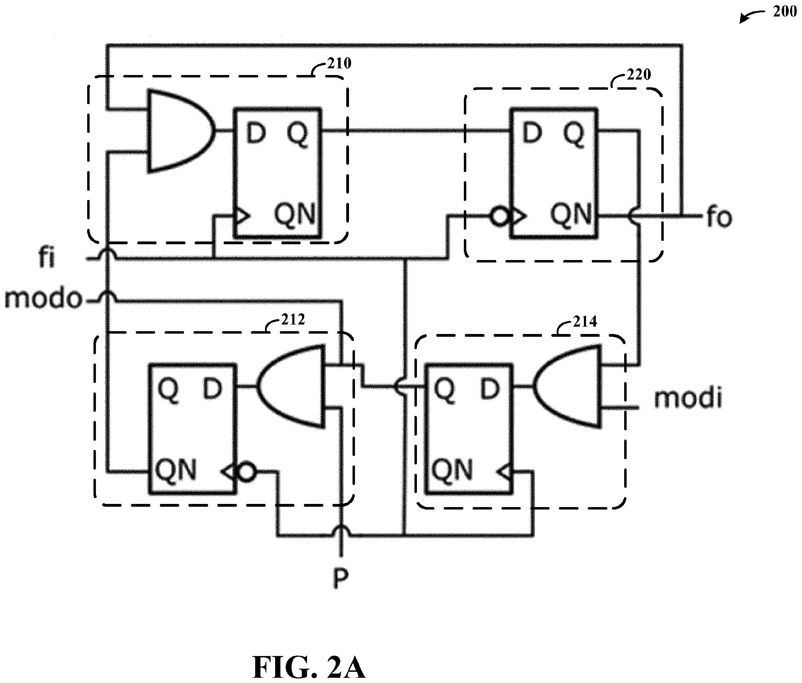

Figure 2A illustrates a frequency divider circuit 200, in accordance with the present disclosure. The frequency divider circuit 200 may, for example, be utilized for latching circuit 110 in Figure 1A. The frequency divider circuit 200 includes latches 210 and 220, and feedback latches 212 and 214. Each of the latch 210 and feedback latches 212 and 214 are modified with AND gates and their respective D-inputs.

In the apparatus 200, the signal fo has a frequency that is equal to a third of the input signal frequency fi divider when both the signal P and modi are enabled. If either of the signals modi or P are disabled, the apparatus 200 behaves like a by-2 frequency divider. The signal modi is enabled by the previous cell operating at lower frequencies, and the 2/3 divider cell generates modo as the input signal for the higher frequency cell. For instance, if implemented as latching circuit 112 in Figure 1A, modi can be received as mod2, and modo can be provided as mod1.

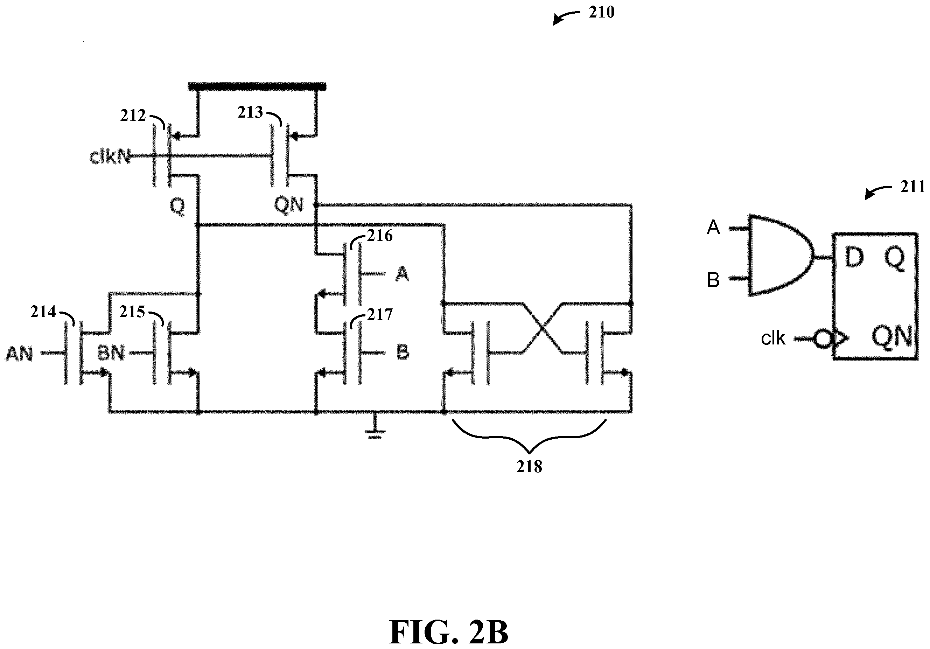

Figure 2B shows a latching circuit 210, which may be implemented in connection with Figure 2A (e.g., as cell 210), in accordance with the present disclosure. Latching circuit 210 may also be implemented with latching circuit 110 of Figure 1A. Circuit 211 is an equivalent representation of circuit 210. The latching circuit 210 includes inverted paths for Q and QN, including clocking input transistor 212 connected to an upper power rail, and transistors 214 and 215 connected in parallel with one another and in series with clocking transistor 212. Clocking input transistor 213 is connected to the upper power rail as well, with transistors 216 and 217 in parallel with one another and clocking input transistor 213. Circuit 218 latches a value provided therewith.

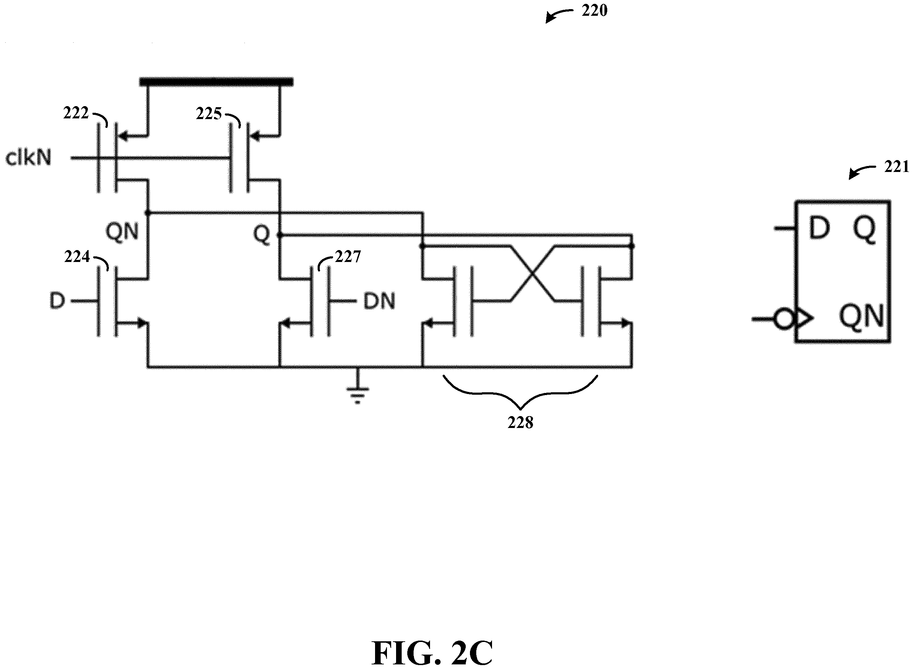

Figure 2C shows a latching circuit 220, which may be implemented in connection with cell 220 in Figure 2A, in accordance with the present disclosure. An equivalent circuit is shown at 221. Latching circuit 220 may further be used in connection with one or more of latching circuits 110, 112, 114 and 116 of Figure 1A. The latching circuit 220 includes transistors 222 and 224 at QN, and transistors 225 and 227 at Q, with circuit 228 operable for latching a value therein.

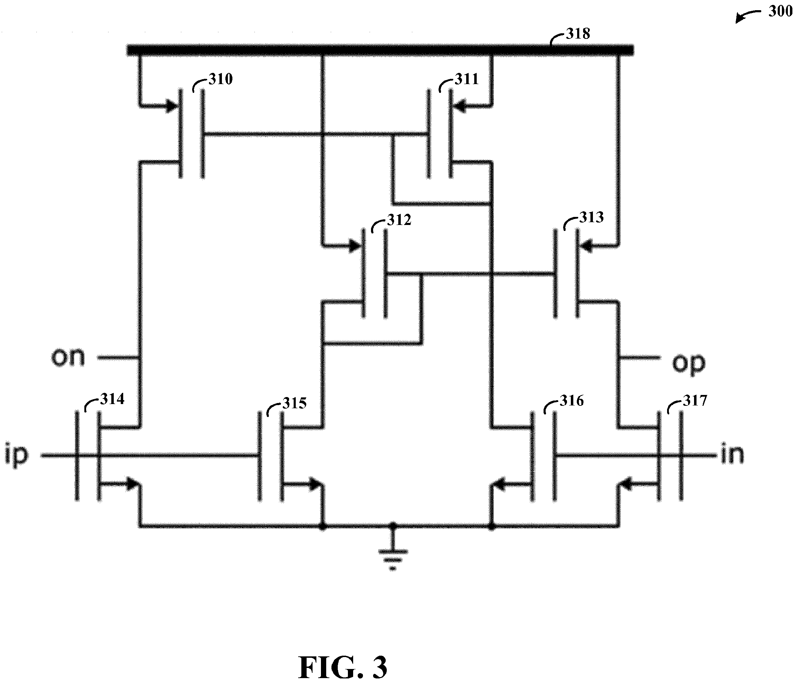

Figure 3 shows a pulse-widening circuit 300, as may be implemented in accordance with one or more aspects of the disclosure. For instance, the pulse-widening circuit 300 may be implemented as or with pulse-widening circuit 120 of Figure 1A. The pulse-widening circuit 300 includes transistors 310-317, connected between an upper rail 318 and ground.

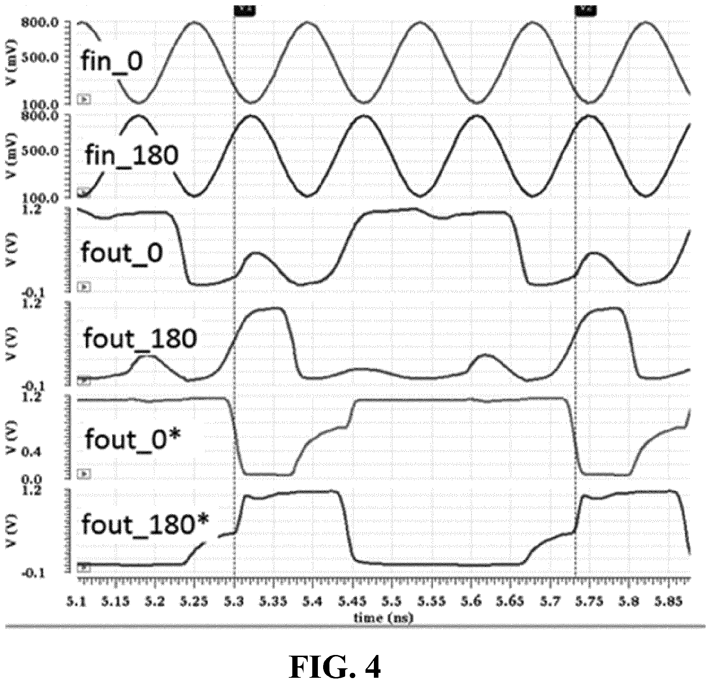

Figure 4 shows plots of an input signal fin_0/fin_180, output signal fout_0/fout_180, and pulse-widened output signal fout_0*/fout_180*, as may be implemented in accordance with one or more aspects of the disclosure. The pulse-widened output signals may be provided, for example, using pulse widening circuitry 120 of Figure 1A and/or pulse widening circuit 300 in Figure 3. The respective input and output signals fin_0/fin_180, and fout_0/fout_180 may correspond to the input and output signals of latching circuitry 110, and the pulse-widened output signal fout_0*/fout_180* provided from pulse widening circuitry 120.

According to an embodiment, a multi-module frequency divider circuit is provided, which comprises a first latching circuit having N vertically-stacked transistors between power rails, where N is less than or equal to three, and being configured and arranged to provide an output signal; a second latching circuit having an input circuit configured and arranged to latch an input signal derived from the output signal of the first latching circuit; and a pulse widening circuit configured to modify a signal derived from the output signal from the first latching circuit to cause the second latching circuit to effect a latching operation as part of a multi-module frequency division operation involving both the first and second latching circuits.

According to an example, the first latching circuit has multiple latches, each having no more than three vertically-stacked transistors.

According to an example, the first latching circuit includes a latch cell having a clocked input port, a signal input port, and a signal output port configured to provide, in response to a signal at the clocked input port, a latched output signal corresponding to a signal at the signal input port.

According to an example, the first latching circuit includes a plurality of latch cells having a clocked input port, a signal input port, and a signal output port configured to provide, in response to a signal at the clocked input port, a latched output signal corresponding to a signal at the signal input port. At least two of the latch cells are modified with an AND gate.

According to an example, the pulse widening circuit is configured to modify the signal derived from the output signal from the first latching circuit by stretching or delaying the signal.

According to an example, the first latching circuit is part of a frequency divider circuit having a plurality of latches, one of the latches including the first latching circuit.

According to an example, the first latching circuit is configured and arranged to divide the frequency of an incoming signal by a selected one of two or more different integers, based on an input select signal provided to the first latching circuit.

According to an example, the first and second latching circuits are frequency divider circuits, each frequency divider circuit being configured and arranged to divide the frequency of a signal input thereto by an integer.

According to an example, the respective latching circuits are configured and arranged to divide the frequency of the signal input to the first latching circuit by a plurality of different values, based on respective combinations of input select signals provided to each latching circuit, with the resulting frequency divided signal being provided at an output of the second latching circuit.

According to an example, the pulse widening circuit is configured and arranged with the first latching circuit to modify the signal derived from the output signal of the first latching by widening a pulse of the output signal of the first latching circuit and therein facilitating the second latching circuit's ability to detect the widened pulse.

According to an example, the first latching circuit includes an input latch circuit; an output latch circuit having an input port connected to receive an output of the input latch circuit; and a feedback loop including a first feedback latch circuit connected to receive an output of the output latch circuit, and a second feedback latch circuit having an input port connected to receive an output of the first feedback latch circuit, the second feedback latch circuit having an output connected to an input of the input latch circuit.

According to an example, the input latch circuit, output latch circuit, first feedback latch circuit and second feedback latch circuit include D-latches, and the input latch circuit, first feedback latch circuit and second feedback latch circuit each have an AND gate connected to a D-input port of their D-latch.

According to an example, the multi-module frequency divider circuit further includes a feedback circuit configured and arranged to provide a feedback signal from the second latching circuit to the first latching circuit, the first latching circuit being configured and arranged to divide by a first integer in the presence of the feedback signal, and to divide by a second integer in the absence of the feedback signal.

According to an embodiment, an apparatus is provided, which comprises a latching circuit having N vertically-stacked transistors between power rails, where N is less than or equal to three, and being configured and arranged to receive an input signal having a frequency; select one of at least two integers for frequency division based upon a control signal; divide the frequency of the input signal by the selected one of the at least two integers to provide an output signal as a frequency-divided representation of the input signal; and a pulse widening circuit configured to modify the output signal by widening a pulse of the output signal.

According to an example, the apparatus further includes at least one additional latching circuit configured and arranged to receive the output signal from the latching circuit, and to divide the frequency of the output signal to provide a further output signal having a frequency that is a divided representation of the frequency of the output signal from the latching circuit.

According to an embodiment, a method for multi-module frequency division, the method comprises providing an output signal from an input signal, using a first latching circuit having N vertically-stacked transistors between power rails, where N is less than or equal to three; modifying a signal derived from the output signal from the first latching circuit with a pulse widening circuit, therein providing a modified output signal; and latching the modified output signal, in a second latching circuit having an input circuit that is configured to receive the modified output signal from the pulse widening circuit, as part of a multi-module frequency division operation involving both the first and second latching circuits.

According to an example, the first latching circuit has multiple latches, each having no more than three vertically-stacked transistors.

According to an example, providing the output signal from the first input signal using the first latching circuit includes dividing the frequency of the input signal by one of two or more different integers, based on an input select signal.

According to an example, providing the output signal from the first input signal using the first latching circuit includes dividing the frequency of the input signal to provide the output signal as a frequency-divided representation of the input signal, and latching the modified output signal in the second latching circuit includes dividing the frequency of the modified output signal to provide a further output signal as a frequency-divided representation of the modified output signal.

According to an example, modifying the signal derived from the output signal with the pulse widening circuit includes widening the signal derived from the output signal to a width that is sufficiently wide to facilitate subsequent latching of the modified output signal.

Based upon the above discussion and illustrations, those skilled in the art will readily recognize that various modifications and changes may be made to the various embodiments without strictly following the exemplary embodiments and applications illustrated and described herein. For example, alternate circuitry may be combined to provide a similar function as to the circuitry disclosed. Such modifications do not depart from the true spirit and scope of various aspects of the disclosure, including aspects set forth in the claims.

**Claims**

1. A multi-module frequency divider circuit, comprising:

   a first latching circuit (110, 200) having N vertically-stacked transistors between power rails, where N is less than or equal to three, and being configured and arranged to provide an output signal;
   a second latching circuit (112-116, 130, 200) having an input circuit configured and arranged to latch an input signal derived from the output signal of the first latching circuit (110, 200); and
   a pulse widening circuit (120, 300) configured to modify a signal derived from the output signal from the first latching circuit (110, 200) to cause the second latching circuit (112-116, 130, 200) to effect a latching operation as part of a multi-module frequency division operation involving both the first and second latching circuits (110, 200, 112-116, 130).

2. The multi-module frequency divider circuit of claim 1, wherein the first latching circuit (110, 200) has multiple latches (210-214), each having no more than three vertically-stacked transistors.

3. The multi-module frequency divider circuit of claim 1 or claim 2, wherein the first latching circuit (110, 200) includes a latch cell having a clocked input port, a signal input port, and a signal output port configured to provide, in response to a signal at the clocked input port, a latched output signal corresponding to a signal at the signal input port.

4. The multi-module frequency divider circuit of any preceding claim, wherein the first latching circuit (110, 200) includes:

   a plurality of latch cells (210-214) having a clocked input port, a signal input port, and a signal output port configured to provide, in response to a signal at the clocked input port, a latched output signal corresponding to a signal at the signal input port; and
   wherein at least two of the latch cells (212, 214) are modified with an AND gate.

5. The multi-module frequency divider circuit of any preceding claim, wherein the pulse widening circuit (120, 300) is configured to modify the signal derived from the output signal from the first latching circuit (110, 200) by stretching or delaying the signal.

6. The multi-module frequency divider circuit of any preceding claim, wherein the first latching circuit (110, 200) is part of a frequency divider circuit (100) having a plurality of latches, one of the latches including the first latching circuit (110, 200).

7. The multi-module frequency divider circuit of any preceding claim, wherein the first latching circuit (110, 200) is configured and arranged to divide the frequency of an incoming signal by a selected one of two or more different integers, based on an input select signal provided to the first latching circuit (110, 200).

8. The multi-module frequency divider circuit of any preceding claim, wherein the first and second latching circuits (110, 200, 112-116, 130) are frequency divider circuits, each frequency divider circuit being configured and arranged to divide the frequency of a signal input thereto by an integer.

9. The multi-mode frequency divider circuit of claim 8, wherein the respective latching circuits are configured and arranged to divide the frequency of the signal input to the first latching circuit (110, 200) by a plurality of different values, based on respective combinations of input select signals provided to each latching circuit, with the resulting frequency divided signal being provided at an output of the second latching circuit (112-116, 130, 200).

10. The multi-module frequency divider circuit of any preceding claim, wherein the pulse widening circuit (120, 300) is configured and arranged with the first latching circuit (110, 200) to modify the signal derived from the output signal of the first latching by widening a pulse of the output signal of the first latching circuit (110, 200) and therein facilitating the second latching circuit's ability to detect the widened pulse.

11. The multi-module frequency divider circuit of any preceding claim, wherein the first latching circuit (110, 200) includes:

   an input latch circuit (210);
   an output latch circuit (220) having an input port connected to receive an output of the input latch circuit; and
   a feedback loop including a first feedback latch circuit (214) connected to receive an output of the output latch circuit (220), and a second feedback latch circuit (212) having an input port connected to receive an output of the first feedback latch circuit (214), the second feedback latch circuit (212) having an output connected to an input of the input latch circuit (210).

12. The multi-module frequency divider circuit of claim 11, wherein
the input latch circuit (210), output latch circuit (220), first feedback latch circuit (214) and second feedback latch circuit (212) include D-latches, and
the input latch circuit (210), first feedback latch circuit (214) and second feedback latch circuit (212) each have an AND gate connected to a D-input port of their D-latch.

13. The multi-module frequency divider circuit of any preceding claim, further including a feedback circuit configured and arranged to provide a feedback signal from the second latching circuit (112-116, 130, 200) to the first latching circuit (110, 200), the first latching circuit (110, 200) being configured and arranged to divide by a first integer in the presence of the feedback signal, and to divide by a second integer in the absence of the feedback signal.

14. A method for multi-module frequency division, the method comprising:

   providing an output signal from an input signal, using a first latching circuit (110, 200) having N vertically-stacked transistors between power rails, where N is less than or equal to three;
   modifying a signal derived from the output signal from the first latching circuit (110, 200) with a pulse widening circuit (120, 300), therein providing a modified output signal; and
   latching the modified output signal, in a second latching circuit (112-116, 130, 200) having an input circuit that is configured to receive the modified output signal from the pulse widening circuit (120, 300), as part of a multi-module frequency division operation involving both the first and second latching circuits (110, 200, 112-116, 130).

15. The method of claim 14, wherein the first latching circuit (110, 200) has multiple latches, each having no more than three vertically-stacked transistors.

EP 3 579 416 A1

**FIG. 1A**

**FIG. 1B**

**FIG. 2A**

EP 3 579 416 A1

**FIG. 2B**

EP 3 579 416 A1

**FIG. 2C**

FIG. 3

EP 3 579 416 A1

FIG. 4

Europäisches
Patentamt

European
Patent Office

Office européen
des brevets

# EUROPEAN SEARCH REPORT

Application Number

EP 19 17 6607

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 163 181 A (NISHIYAMA SEIICHI [JP]) 19 December 2000 (2000-12-19) | 1-3,5,6, 8,10,14, 15 | INV. H03K23/64 H03K23/66 |
| A | * abstract; figures 3,4,7a-7n,8a-8n * * column 1, line 5 - column 2, line 67 * ----- | 4,11-13 | |
| X | VAUCHER C S ET AL: "A family of low-power truly modular programmable dividers in standard 0.35-/spl mu/m CMOS technology", IEEE JOURNAL OF SOLID-STATE CIRCUITS, IEEE SERVICE CENTER, PISCATAWAY, NJ, USA, vol. 35, no. 7, 1 July 2000 (2000-07-01), pages 1039-1045, XP011450284, ISSN: 0018-9200, DOI: 10.1109/4.848214 | 1,3-8, 10-12,14 | |
| A | * abstract; figures 2,4,5 * ----- | 2,9,13, 15 | |
| A | WO 02/093747 A2 (KONINKL PHILIPS ELECTRONICS NV [NL]; WANG ZHENHUA [NL]) 21 November 2002 (2002-11-21) * abstract; figures 2,6a * ----- | 1-15 | |
| | | | TECHNICAL FIELDS SEARCHED (IPC) |
| A | CN 101 800 536 A (CHINESE ACAD INST ELECTRONICS) 11 August 2010 (2010-08-11) * figures 3,4,5,8a,8b * ----- | 1-6, 8-10,14, 15 | H03K |

The present search report has been drawn up for all claims

| Place of search | Date of completion of the search | Examiner |
|---|---|---|
| Munich | 29 October 2019 | Mesic, Maté |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 19 17 6607

This annex lists the patent family members relating to the patent documents cited in  the above-mentioned European search report.
The members are as contained in the European Patent Office EDP file on
The European Patent Office is in no way liable for these particulars which are merely given for the purpose of information.

29-10-2019

| Patent document cited in search report | | Publication date | Patent family member(s) | | Publication date |
|---|---|---|---|---|---|
| US 6163181 | A | 19-12-2000 | CN | 1215257 A | 28-04-1999 |
| | | | JP | 4150092 B2 | 17-09-2008 |
| | | | JP | H1198009 A | 09-04-1999 |
| | | | KR | 19990029817 A | 26-04-1999 |
| | | | US | 6163181 A | 19-12-2000 |
| WO 02093747 | A2 | 21-11-2002 | CN | 1593008 A | 09-03-2005 |
| | | | EP | 1490973 A2 | 29-12-2004 |
| | | | JP | 2005508577 A | 31-03-2005 |
| | | | US | 2004140831 A1 | 22-07-2004 |
| | | | WO | 02093747 A2 | 21-11-2002 |
| CN 101800536 | A | 11-08-2010 | NONE | | |

EPO FORM P0459

For more details about this annex : see Official Journal of the European Patent Office, No. 12/82